(19) **Europäisches Patentamt European Patent Office Office européen des brevets**

(11) **EP 4 637 172 A1**

## (12) EUROPEAN PATENT APPLICATION

(43) Date of publication:
**22.10.2025 Bulletin 2025/43**

(21) Application number: **25169776.9**

(22) Date of filing: **10.04.2025**

(51) International Patent Classification (IPC):
*H04N 25/445* (2023.01)   *H04N 25/46* (2023.01)
*H04N 25/621* (2023.01)   *H04N 25/709* (2023.01)

(52) Cooperative Patent Classification (CPC):
**H04N 25/445; H04N 25/46; H04N 25/621; H04N 25/63; H04N 25/709**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **18.04.2024 IL 31230624**
**16.03.2025 IL 31964825**

(71) Applicant: **Semiconductor Devices Ltd.**
**D.N. Misgav, 2017900 (IL)**

(72) Inventors:
• **BEN-ARI, Nimrod**
  **2010300 Gilon (IL)**
• **JAKOBSON, Claudio Gabriel**
  **2199685 Karmiel (IL)**
• **DOBROMISLIN, Roman**
  **34608 Haifa (IL)**
• **BERKOWICZ, Eyal**
  **Ein Ayala (IL)**
• **KLIPSTEIN, Philip**
  **3090715, Zikhron Ya'akov (IL)**

(74) Representative: **Zacco GmbH**
**Bayerstrasse 83**
**80335 München (DE)**

(54) **PIXEL COUPLING**

(57)   An imaging system comprising: a focal plane array (FPA) comprising a plurality of photodiodes, hosted by a shared substrate, each photodiode having a collection node; a pixel circuitry array (PCA) comprising a plurality of transistors, an input node of a transistor of the plurality of transistors connected to each photodiode collection node of the FPA; and biasing circuitry configured to: selectively bias a first portion of the plurality of transistors into an inactive configuration; reverse bias a substrate of each transistor of the first portion of the plurality of transistors; and selectively bias a second portion of the plurality of transistors into an active configuration; reverse bias the shared substrate to a different reverse bias than the reverse bias of each the transistor substrate of the first portion of the plurality of transistors.

EP 4 637 172 A1

## Description

### TECHNOLOGICAL FIELD

The present disclosure, in some embodiments, thereof, relates to optical detection using a focal plane array (FPA) and a readout integrated circuit (ROIC) and, more particularly, but not exclusively, to low light level (LLL) imaging using the FPA and ROIC.

### BACKGROUND ART

Acknowledgement of the above references herein is not to be inferred as meaning that these are in any way relevant to the patentability of the presently disclosed subject matter.

### GENERAL DESCRIPTION

Example 1. An imaging system comprising:

a focal plane array (FPA) comprising a plurality of photodiodes, hosted by a shared substrate, each photodiode having a collection node;
a pixel circuitry array (PCA) comprising a plurality of transistors, an input node of a transistor of said plurality of transistors connected to each photodiode collection node of said FPA; and
biasing circuitry configured to:

selectively bias a first portion of said plurality of transistors into an inactive configuration;
reverse bias a substrate of each transistor of said first portion of said plurality of transistors; and
selectively bias a second portion of said plurality of transistors into an active configuration;

reverse bias said shared substrate to a different reverse bias than said reverse bias of each said transistor substrate of said first portion of said plurality of transistors.

Example 2. The imaging system according to claim 1, wherein each transistor of said second portion injects photocurrent signal received from the connected photodiode collection node away from the transistor.
Example 3. The imaging system according to claim 2, wherein injection of photocurrent of said transistors of said second portion prevent charge accumulation at photodiodes connected to transistors of said second portion.
Example 4. The imaging system according to any one of claims 2-3, wherein injection of photocurrent of said transistors of said second portion maintains said reverse bias of said shared substrate.
Example 5. The imaging system according to any one of claims 1-4, wherein said FPA is hosted by a FPA wafer, wherein said PCA is hosted by a PCA wafer which is a different wafer to said FPA wafer.
Example 6. The imaging system according to claim 5, wherein said FPA wafer includes direct bandgap material.
Example 7. The imaging system according to any one of claims 5-6, wherein said FPA wafer is a heterostructure.
Example 8. The imaging system according to claim 7, wherein said photodiode collection nodes include material having a wider bandgap than said shared substrate.
Example 9. The imaging system according to any one of claims 1-8, wherein said photodiodes are infrared detecting photodiodes with a photon absorbing region including InGaAs, InSb, or HgCdTe.
Example 10. The imaging system according to any one of claims 5-9, wherein said PCA wafer comprises silicon and said plurality of transistors comprise metal-oxide-semiconductor field effect transistors (MOSFETs).
Example 11. The imaging system according to any one of claims 1-10, comprising a plurality of connectors, each said transistor connected to a corresponding photodiode of said plurality of photodiodes by a connector of said plurality of connectors.
Example 12. The imaging system according to claim 11, wherein said plurality of connectors comprise one of copper-to-copper connections and indium bumps.
Example 13. The imaging system according to any one of claims 1-11, wherein first portion photodiodes of said FPA associated with said first portion of transistors are spatially interspersed on said FPA with second portion photodiodes of said FPA associated with said second portion of transistors, each active transistor of said second portion collecting photocurrent from a second portion photodiode and at least one first portion photodiode.
Example 14. The imaging system according to claim 13, wherein said first portion photodiodes and said second portion photodiodes, for at least a part of said FPA, are evenly distributed, each active transistor of said second portion collecting photocurrent from an equal number of photodiodes of said first portion.

Example 15. The imaging system according to any one of claims 1-14, wherein each said photodiode is connected to an input node of a transistor of said plurality of transistors;

wherein substrates of transistors of said first portion are reverse biased to reverse bias said input nodes to prevent leakage of charge from said input nodes of said transistors of said first portion to said substrates.

Example 16. The imaging system according to claim 15, wherein substrates of transistors of said second portion are reverse biased.

Example 17. The imaging system according to any one of claims 15-16, wherein said photodiodes and transistors are implemented in a p-type configuration;

wherein substrates of said photodiodes are reverse biased to a reverse biasing voltage Vdetcom; and
wherein said substrates of said transistors of said first portion are reverse biased to a voltage Vhigh which is higher than said reverse biasing voltage Vdetcom of said photodiodes; Vhigh > Vdetcom.

Example 18. The imaging system according to any one of claims 12-17, wherein said biasing circuitry is configured to deactivate transistors of said first portion by biasing switching terminals of transistors of said first portion to a deactivation voltage and to activate transistors of said second portion by biasing switching terminals of transistors of said second portion to an activation voltage, which is different than said deactivation voltage.

Example 19. The imaging system according to any one of claims 12-17, wherein said PCA comprises a plurality of rows of pixel circuits, wherein switching terminals of transistors of each row of pixel circuits of the pixel circuit array are biased to a same voltage, said first portion comprising at least one row of said pixel circuit array.

Example 20. The imaging system according to any one of claims 12-17, wherein said PCA comprises a plurality of rows of pixel circuits, wherein one or more row of pixel circuits of said pixel circuit array includes a plurality of bias lines, to bias switching terminals of different transistors of said row to different voltages; and
wherein said biasing circuitry is configured to supply different bias voltages to at least two of said plurality of bias lines.

Example 21. The imaging system according to claim 20, wherein said different bias voltages include:

said activation voltage to bias a portion of said transistors of said one or more row into said active configuration; and
said deactivation voltage to bias a portion of said transistors of said one or more row into said inactive configuration.

Example 22. The imaging system according to any one of claims 18-21, wherein said transistors are field effect transistors (FETs) and said switching terminals are gates of said FETs.

Example 23. The imaging system according to any one of claims 18-21, wherein said transistors are bipolar junction transistors (BJTs) and said switching terminals are bases of said BJTs.

Example 24. The imaging system according to any one of claims 12-23, wherein said pixel circuits each include read-out circuitry.

Example 25. The imaging system according to claim 24, wherein said read-out circuitry includes an integration capacitor connected to a transistor of a respective pixel circuit for accumulating charge received through said transistor.

Example 26. The imaging system according to any one of claims 24-25, wherein said read-out circuitry comprises a charge trans-impedance amplifier (CTIA).

Example 27. The imaging system according to any one of claims 24-25, wherein said read-out circuitry comprises direct injection (DI) read-out circuitry.

Example 28. The imaging system according to any one of claims 24-25, wherein said read-out circuitry comprises one of:

buffer direct injection (BDI) read-out circuitry;
source-follower per detector (SFD) read-out circuitry;
gate-modulation input (GMI) read-out circuitry;
share-buffered direct injection (SBDI) read-out circuitry; or
switch current integration (SCI) read-out circuitry.

Example 29. The imaging system according to any one of claims 12-28, comprising processing circuitry configured to receive image data from said PCA, where less than the number of pixels.

Example 30. An imaging method for using a focal plane array (FPA) having a plurality of photodiodes hosted by a shared substrate and a pixel circuit array (PCA) coupled to the FPA and having a plurality of transistors, a transistor corresponding to each photodiode of said FPA, which method comprising:

selecting a first portion of said plurality of transistors as inactive transistors and a second portion of said plurality of transistors as active transistors;

biasing said first portion transistors into an inactive configuration and biasing said second portion transistors into an active configuration;

reverse biasing said shared substrate to reverse bias photodiodes connected to transistors of said second portion;

reverse biasing a substrate of each transistor of said first portion of said plurality of transistors to a different reverse bias than that of said shared substrate; and

acquiring one or more image using said FPA and said PCA.

Example 31. The method according to claim 30, wherein said biasing comprises reverse biasing substrates of transistors of said first portion to a stronger reverse bias than that of the shared substrate of said photodiodes to prevent leakage of charge from said transistors of said first portion to said substrates.

Example 32. The method according to claim 31, wherein said FPA and PCA are implemented in a p-type configuration, wherein reverse biasing comprises biasing said photodiodes to a voltage Vdetcom;

wherein said reverse biasing substrates comprises biasing said substrates to a voltage Vhigh, where Vhigh > Vdetcom.

Example 33. The method according to any one of claims 30-32, wherein said biasing comprises biasing switching terminals of transistors of said first portion to a deactivation voltage and biasing switching terminals of transistors of said second portion to an activation voltage, which is higher than said deactivation voltage.

Example 34. The method according to any one of claims 30-33, wherein said selecting comprises selecting active transistors spatially interspersed with said inactive transistors.

Example 35. The method according to any one of claims 30-34, wherein said selecting said first portion comprises selecting one or more row of said PCA; and

wherein said biasing comprises biasing transistors of said one or more row into said inactive configuration.

Example 36. The method according to any one of claims 30-35, wherein said acquiring comprises accumulating charge at integration circuitry of pixel circuits associated with said active transistors of said PCA.

Example 37. The method according to claim 36, wherein said acquiring comprises reading and amplifying said charge through read-out circuitry of said pixel circuits associated with said active transistors.

Example 38. An imaging system comprising:

a pixel array comprising:

a focal plane array (FPA) comprising a plurality of photodiodes hosted by a shared substrate, each photodiode having a collection node;

a pixel circuitry array (PCA) comprising a plurality of pixel circuits, each pixel circuit having an input node electrically connected to a collection node of a photodiode;

read-out circuitry;

biasing circuitry configured to:

disconnect input nodes of a first portion of said pixel circuits from the read-out circuitry;

connect input nodes of a second portion of said pixel circuits to the read-out circuitry; and

maintain accumulated charge at the input node of said pixels of the first portion to forward bias photodiodes of said first portion.

Example 39. The imaging system according to any one of claims 1-29, wherein said different reverse bias is a stronger reverse bias.

Following is a non-exclusive list of some exemplary embodiments of the disclosure. The present disclosure also includes embodiments which include fewer than all the features in an example and embodiments using features from multiple examples, even if not listed below.

Unless otherwise defined, all technical and/or scientific terms used within this document have meaning as commonly understood by one of ordinary skill in the art/s to which the present disclosure pertains. Methods and/or materials similar or equivalent to those described herein can be used in the practice and/or testing of embodiments of the present disclosure, and exemplary methods and/or materials are described below. Regarding exemplary embodiments described below, the materials, methods, and examples are illustrative and are not intended to be necessarily limiting.

Some embodiments of the present disclosure are embodied as a system, method, or computer program product. For example, some embodiments of the present disclosure may take the form of an entirely hardware embodiment, an entirely software embodiment (including firmware, resident software, micro code, etc.) or an embodiment combining software and hardware aspects that may all generally be referred to herein as a "circuit," "module" and/or "system."

Implementation of the method and/or system of some embodiments of the present disclosure can involve performing and/or completing selected tasks manually, automatically, or a combination thereof. According to actual instrumentation and/or equipment of some embodiments of the method and/or system of the present disclosure, several selected tasks could be implemented by hardware, by software or by firmware and/or by a combination thereof, e.g., using an operating system.

For example, hardware for performing selected tasks according to some embodiments of the present disclosure could be implemented as a chip or a circuit. As software, selected tasks according to some embodiments of the present disclosure could be implemented as a plurality of software instructions being executed by a computational device e.g., using any suitable operating system.

In some embodiments, one or more tasks according to some exemplary embodiments of method and/or system as described herein are performed by a data processor, such as a computing platform for executing a plurality of instructions. Optionally, the data processor includes a volatile memory for storing instructions and/or data and/or a non-volatile storage e.g., for storing instructions and/or data. Optionally, a network connection is provided as well. User interface/s e.g., display/s and/or user input device/s are optionally provided.

Some embodiments of the present disclosure may be described below with reference to flowchart illustrations and/or block diagrams. For example illustrating exemplary methods and/or apparatus (systems) and/or and computer program products according to embodiments of the present disclosure. It will be understood that each step of the flowchart illustrations and/or block of the block diagrams, and/or combinations of steps in the flowchart illustrations and/or blocks in the block diagrams, can be implemented by computer program instructions. These computer program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart steps and/or block diagram block or blocks.

These computer program instructions may also be stored in a computer readable medium that can direct a computer (e.g., in a memory, local and/or hosted at the cloud), other programmable data processing apparatus, or other devices to function in a particular manner, such that the instructions stored in the computer readable medium can be used to produce an article of manufacture including instructions which implement the function/act specified in the flowchart and/or block diagram block or blocks.

The computer program instructions may also be run by one or more computational device to cause a series of operational steps to be performed e.g., on the computational device, other programmable apparatus and/or other devices to produce a computer implemented process such that the instructions which execute provide processes for implementing the functions/acts specified in the flowchart and/or block diagram block or blocks.

Some of the methods described herein are generally designed only for use by a computer, and may not be feasible and/or practical for performing purely manually, by a human expert. A human expert who wanted to manually perform similar tasks, might be expected to use different methods, e.g., making use of expert knowledge and/or the pattern recognition capabilities of the human brain, potentially more efficient than manually going through the steps of the methods described herein.

## BRIEF DESCRIPTION OF THE DRAWINGS

In order to better understand the subject matter that is disclosed herein and to exemplify how it may be carried out in practice, embodiments will now be described, by way of non-limiting example only, with reference to the accompanying drawings, in which:

FIG. 1 is a simplified schematic of a portion of an imaging system, according to some embodiments of the disclosure;
FIG. 2 is a detection method, according to some embodiments of the disclosure;
FIG. 3A is a simplified schematic of a portion of an FPA and an ROIC, according to some embodiments of the disclosure;
FIG. 3B is a simplified schematic of a portion of a PCA of an ROIC, according to some embodiments of the disclosure;
FIG. 3C is a simplified schematic of a portion of a PCA of an ROIC, according to some embodiments of the disclosure;
FIG. 4 is a simplified schematic cross section of a portion of a detector array and an ROIC, according to some embodiments of the disclosure;
FIG. 5 is a simplified schematic cross section of a portion of a detector array and an ROIC, according to some embodiments of the disclosure;

FIG. 6 is a simplified schematic of circuitry of a portion of an imaging system, according to some embodiments of the disclosure;

FIGs. 7A-B are simplified schematics of exemplary read-out circuitry, according to some embodiments of the disclosure;

FIG. 8 is a simplified schematic of a portion of an imaging system, according to some embodiments of the disclosure;

FIGs. 9A-C are simplified schematics illustrating layout of active and inactive pixels of imaging system portions, according to some embodiments of the disclosure; and

FIGs. 10A-B are simplified schematic band diagrams, according to some embodiments of the disclosure;

FIGs. 11A-B are simplified schematic band diagrams, according to some embodiments of the disclosure.

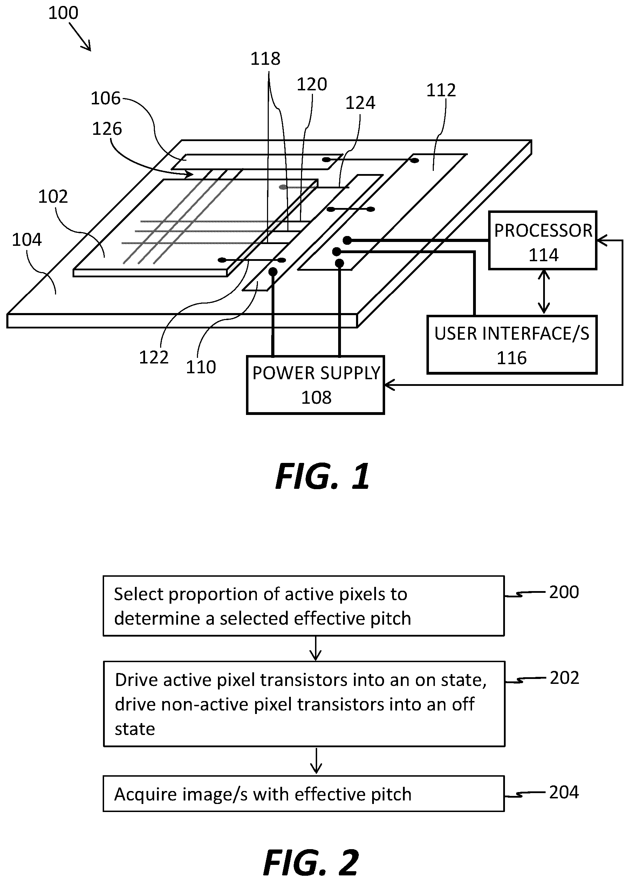

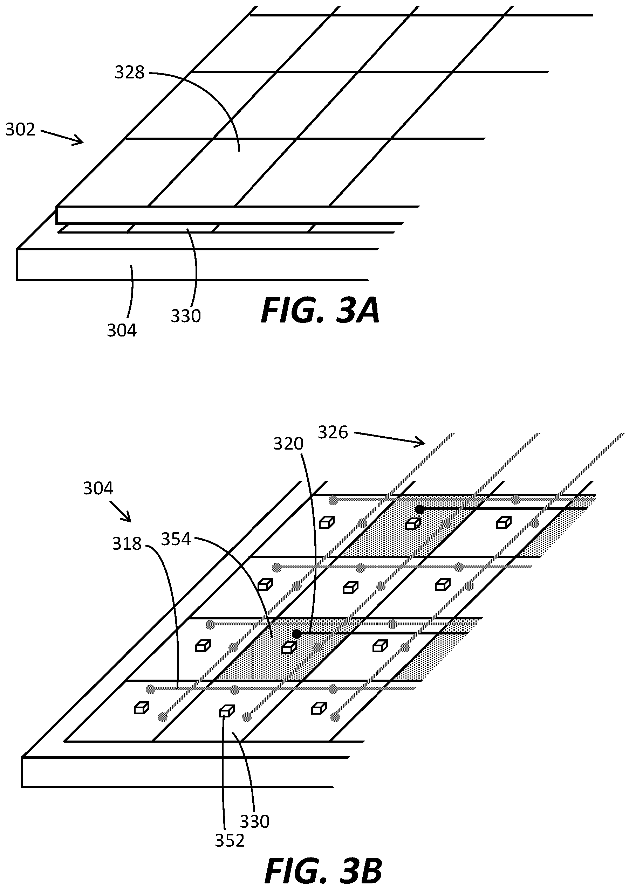

In some embodiments, although non-limiting, in different figures, like numerals are used to refer to like elements, for example, element **102** in FIG. 1 corresponding to element **302** in FIG. 3A.

## DETAILED DESCRIPTION OF EMBODIMENTS

The present disclosure, in some embodiments, thereof, relates to optical detection using a focal plane array (FPA) and a readout integrated circuit (ROIC) and, more particularly, but not exclusively, to low light level (LLL) imaging using the FPA and ROIC.

## Overview

A broad aspect of some embodiments of the invention relates to increasing an effective pixel pitch of a focal plane array (FPA) which includes an array of photodiodes hosted by a shared substrate, by switching off a portion ("herein termed the "first portion") of the photodiodes. The first portion of photodiodes becomes "inactive" where photocarriers generated in the shared substrate, including those in regions of inactive photodiodes, are collected by active photodiodes.

In some embodiments, inactive photodiodes accumulate charge at their collection nodes (and/or element/s electrically connected to these collection nodes accumulate charge). Accumulation of charge carriers at the collection nodes of the inactivated photodiodes may repel photocurrent e.g., including photocurrent generated at a region of the substrate associated with the inactivated photodiode. The repelled carriers are then collected by active photodiodes in the shared substrate e.g., moving to the collection nodes of active photodiodes. In some embodiments, charge accumulates at inactive photodiode collection nodes because flow of charge carriers from the photodiode collection nodes is prevented.

In some embodiments, the FPA is part of an imaging system that includes a plurality of pixel circuits of a pixel circuit array (PCA) where each photodiode of the FPA is connected to an associated pixel circuit of the PCA. Together, the photodiode and pixel circuit are herein termed a "pixel unit". In some embodiments, at least a proportion of charge carriers produced by incident photons in photodiodes (the charge carriers herein termed "photocarriers", and specifically; "photo-holes" and "photo-electrons") associated with inactive photodiodes, pass through a pixel circuit of an active photodiode for detection. In this document, generally, description of "photocarriers" refers to minority carriers in the photon absorbing layer or substrate. (e.g., holes in a n-type system and electrons in a p-type system). In an exemplary embodiment, the photon-absorbing layer (PAL) is n-type, the material is doped with donor impurities to make electrons the majority carriers, holes are the photogenerated minority carriers, and charge transport relies on the collection of minority carriers (holes).

In some embodiments, the FPA is configured to detect infrared (IR) light, where the material of the FPA includes III-V materials, II-VI materials, and other compound semiconductors. In some embodiments, the FPA includes III-V materials, which consist of elements from groups III and V of the periodic table, potential advantage/s including tunable electronic properties and/or the availability of direct bandgap compositions.

An aspect of some embodiments of the disclosure relates to injection of photocurrent arriving at collection nodes of photodiodes through transistors of associated pixel circuits. The collection node of the photodiode may be connected (e.g., via a connector) to an input node of a transistor of a respective pixel circuit. In some embodiments, the transistor of a pixel circuit corresponding to an inactive photodiode is switched off, preventing flow of current from the input node (and photodiode collection node), the transistor input node and the collection node of the photodiode accumulating charge. Transistors and pixel circuits associated with inactive photodiodes are herein termed inactive transistors and inactive pixel circuits, respectively.

In some embodiments, photocarriers are not stored at the collection nodes of the active pixels but are injected (flow continuously) through the active pixel circuits to a storage element (e.g., integration capacitor). A potential advantage of which is that the signal photocurrent does not remain at the active photodiode collection nodes. This may maintain condition/s (e.g., potential) experienced by generated photocurrent, generated photocurrent continuing to be repelled by the inactive photodiode collection nodes and/or continuing to be attracted by the active photodiode collection nodes.

A potential advantage being, for example, in contrast with charge being allowed to accumulate at collection nodes of the active photodiodes (e.g., for periodic discharge to provide a read signal), is that voltage across active photodiodes is maintained, and does not vary during the integration process, e.g., between read times. This may be a particular advantage when the photodiodes are formed with low resistivity materials (e.g., III-V materials) and varying photodiode voltage may result in large dark currents and/or nonlinear amplification of the signal current.

An aspect of some embodiments of the invention relates to biasing transistors of a first portion of the pixel circuits of the PCA into an "off" also termed "inactive" configuration and biasing a second portion of transistors of pixel circuits of the PCA into an "on" also termed "active" configuration. Where the transistors of pixel circuits are each disposed in a current path between a respective photodiode and detection circuitry. In some embodiments, the transistors are FETs (field effect transistors) e.g., MOSFETs (metal oxide silicon FETs) and active transistors are biased to establish a channel between source and drain.

A potential advantage of switching off of a portion of the pixel circuits and detecting photocurrent generated by a plurality of photodiodes at a single pixel circuit is effective summing of detection charge at the photodiodes with low introduction of noise to the detection signal associated with the summing. For example, as noise associated with detection of photocarriers is only that associated with passage through components of a single pixel circuit. For example, thermal noise of one integration capacitor is added to the photocurrent signal of a plurality of photodiodes.

Where noise may be low, for example, in comparison to summing techniques implemented either in the analog domain or in the digital domain. Summing techniques in the analog domain, for example, include summing of detection signals for multiple pixels by parallel connection of the photodiodes or parallel connection of integration capacitors of the pixel circuits. Summing techniques in the digital domain, for example, include summing of detection signals after read-out and analogue to digital (ADC) conversion.

Without wanting to be bound by theory, it is theorized that, assuming that noise sources of different pixels are statistically independent, summing of the signal (e.g., using summing technique/s described in the previous paragraph) also sums the noise variance. Where noise may be approximated by the pixel variances, a total variance for the summed signal is $1/N$ multiplied by the sum (where N is the number of pixels for which measurements are summed). If the signal is approximated by the mean of the measurements, and the noise by the standard deviation, where the standard deviation is the square root of the variance, summing increases the signal to noise ratio (SNR) by the square root of the number of summed pixels $\sqrt{N}$.

Furthermore, it is theorized that summing increases readout noise floor by the same factor $\sqrt{N}$. Where, in a simplified picture, the noise of an imager system includes shot noise, which is dependent upon the signal, and the readout noise, which is fixed and exists with or without a signal. Depending on design, when the signal is large with respect to the readout noise, shot noise is dominant and readout noise may be neglected. However, for a scarce signal (e.g., during LLL) readout noise may be the dominant noise. Summing increases the signal level, but for a scarce signal this may not compensate for summing of the readout noise.

In contrast, it is theorized that summing of detection signals by biasing pixel units inactive to effectively sum the signal at an active pixel unit does not increase the readout noise, potentially improving SNR e.g., for low light levels where readout noise may be significant with respect to the signal.

When higher light levels are being detected (e.g., where readout noise is less significant and/or may be ignored) biasing of pixel units inactive for a same time period theoretically provides a larger detection signal on integration capacitors of the active pixel units potentially enabling increased imaging frame rates (e.g., the capacitor has higher charge and may be read/discharged more frequently).

In some embodiments, active pixels units (and associated pixel circuits including transistors) are adjacent to inactive pixel units, an area of the FPA associated with both the active pixel unit and adjacent inactive pixel units forming an enlarged detector pixel area (e.g., where active photodiodes are evenly dispersed on at least a region of the FPA, the region then effectively having an enlarged pixel pitch).

An aspect of some embodiments of the invention relates to preventing leakage of accumulated charge from the inactive photodiode collection nodes and input nodes of associated transistors. A potential advantage being increased accuracy of the detection signal provided by the active pixel units. In some embodiments, leakage is prevented by biasing the substrate of the input nodes of inactive pixel circuits.

In some embodiments, the pixel circuits are separated from the photodiodes. Where the photodiodes may be hosted by a different material to the pixel circuits and/or where the material characteristics of the photodiode and input node may be different.

In an exemplary embodiment, photodiodes and pixel circuits are hosted by different wafers, each photodiode connected to a pixel circuit (an input node thereof) by a connector. In some embodiments, the photodiodes and pixel circuits are hosted by wafers formed of different materials e.g., the pixel circuits on a silicon wafer and the photodiodes on a III-V material substrate.

In some embodiments, separation between the pixel circuits and photodiode enables and/or eases the implementation of different biasing of the substrates of the pixel circuits and the photodiodes. For example, enable different biasing of the input node of the inactive pixel circuit (e.g., differently from the biasing of the photodiode), for example, to prevent leakage of the accumulated charge.

A potential advantage of separating the photodiodes from the pixel circuitry is reduced (e.g., lack of) noise associated with parasitic light. Parasitic light being where photocurrent is generated at non-photodiode structure/s (e.g., at p-n junctions associated with pixel circuitry).

In some embodiments, the input node of the active pixel is biased to what may be termed an "increased reverse bias magnitude", or a "higher reverse voltage magnitude" or "stronger reverse bias" compared to the bias voltage applied to the photodiode substrate to reverse bias the photodiodes. In a p-type system (also termed an "p-on-n type system" where the transistors and photodiodes are formed on n-type substrates), the stronger reverse bias includes applying a more positive voltage to the n-type substrate of the inactive transistor than that applied to the n-type photodiode substrate. In a n-type system (also termed an "n-on-p type system" where the transistors and photodiodes are formed on n-type substrates), the stronger reverse bias includes applying a more negative voltage to the p-type substrate of the inactive transistor than that applied to the p-type photodiode substrate.

A potential benefit of this stronger reverse bias on the inactive transistor substrate being prevention of leakage of accumulated charge out of inactive pixel units, without disadvantageous change to biasing of the photodiodes of the FPA e.g., which may be selected for optimal light detection. The biasing of the input node of the inactive pixel unit transistors may be understood as preventing accumulated charge (as received from the collection node of the inactive photodiode) from forward biasing the junction between the input node and its substrate.

The ability to reduce leakage without changing bias of the photodiodes may be a particular advantage where the photodiodes are hosted by lower resistivity material and/or material which has higher propensity for dark current (e.g., as associated with higher levels of impurities and/or crystalline non-ideality). For example, when the photodiodes are implemented in III-V material/s and/or using heterostructures

In some embodiments, active photodiodes of the FPA are reverse biased. Where, for inactive pixel units, a terminal (herein termed "transistor input node") of the transistor of the associated inactive pixel circuit connected to the photodiode is also reverse biased with respect to the substrate and/or channel of the transistor. Without wanting to be bound by theory, it is theorized that the biasing produces a charge carrier potential well at the node (herein termed "floating node") where the node includes the portion of the photodiode (herein termed photodiode "collection node") connected to a portion of the transistor. It is theorized that charge carriers accumulate in the potential well, and, once the well is filled, additional photocarriers generated in the photodiode substrate are repelled by the charge occupying the well, the additional carriers then diffusing towards the active transistor for detection at pixel circuitry of an active transistor.

The accumulated charge at the inactive photodiode collection node may locally change bias of the inactive photodiode collection node - photodiode substrate junction, potentially repelling generated photocarriers (e.g., the junction becomes forward biased).

Similarly, as associated with electrical connection of the inactive photodiode collection node to the inactive transistor input node, the inactive transistor input node could tend to become forward biased. In some embodiments, this is prevented (and therefore leakage from the inactive transistor input node into the transistor substrate is potentially prevented) by biasing the transistor substrate.

In some embodiments, the inactive transistor substrate biasing is configured to provide equilibrium conditions at the inactive transistor input node - transistor substrate interface. The inactive transistor substrate biasing may be configured to minimize reverse bias which may contribute to carrier injection from the transistor substrate through to the photodiode substrate, potentially contributing to photocurrent noise where these "dark current" carriers may be collected at active pixel units.

Additionally or alternatively, in some embodiments, biasing of the inactive transistor substrate may be configured to minimize forward bias at the inactive transistor input node - transistor substrate junction which may contribute to carrier leakage from the inactive transistor input node into the transistor substrate, potentially resulting in acquisition of generated photocarriers by the inactive photodiode collection node.

In some embodiments, for example, under LLL where photocurrent levels are low, the biasing may be selected to put the inactive transistor input node - transistor substrate into reverse bias, noise increasing the photocurrent being selected in this tradeoff.

In some embodiments, the transistors are p-type transistors, where a p-type portion of each photodiode is connected to a drain of the associated transistor. Biasing of the n-type portion of the photodiode (e.g., n-type substrate of the FPA) is high as is biasing of the inactive transistor substrate and gate. Biasing of the active transistor gate may be configured to provide a channel to the active transistor device.

Optionally, substrate/s of active transistors may be biased to the same voltage as the substrate/s of inactive transistors. Where the transistor substrate bias may be a stronger reverse bias than that of the photodiode reverse bias (more negative in a p-type system). For the active transistor, it is theorized that the bias experienced at the junction between the transistor input node and the transistor substrate, is dominated by the active channel of the transistor, potentially providing equilibrium conditions preventing leakage of photocurrent into the transistor substrate and/or injection of carriers into the transistor input node from the transistor substrate. In some embodiments, a reverse bias may be experienced at the active transistor input node - active transistor substrate junction where it is theorized that injection current from the substrate is low with respect to the photocurrent measurement signal.

In some embodiments, the FPA is configured to detect light in the near-infrared (NIR) and shortwave infrared (SWIR) regions where the photodiodes may include III-V materials such as Indium Gallium Arsenide (InGaAs), Gallium Arsenide (GaAs), and Indium Phosphide (InP), all of which exhibit direct bandgap behavior.

In some embodiments, the FPA is configured to detect light in the midwave infrared (MWIR) and/or longwave infrared (LWIR) where the FPA may include compound semiconductors such as Mercury Cadmium Telluride (HgCdTe), Lead Selenide (PbSe), and Lead Sulfide (PbS).

Additionally, in some embodiments, the FPA may include material/s such as Gallium Antimonide (GaSb), Indium Antimonide (InSb), and Indium Arsenide (InAs), Aluminum Gallium Arsenide (AlGaAs), Indium Gallium Phosphide (InGaP).

In some embodiments, an imaging system including the FPA and PCA is used in infrared imaging under low light levels (LLL). Where in some embodiments, LLL conditions may be defined as corresponding to a natural night environment, e.g., ranging from full moon illumination down to moonless conditions, or intermediate illumination levels therein. In some embodiments, LLL conditions may be defined as resulting in a charge generation of 10ke or lower for a pixel size of approximately $10\mu m^2$. The specific charge level may depend on pixel size, where larger pixels may accumulate greater charge, while smaller pixels may accumulate lesser charge. In some embodiments, LLL conditions correspond to photocurrents that necessitate active amplification schemes, such as capacitive transimpedance amplifier (CTIA) architecture e.g., where the generated photocurrents may be too low to adequately bias passive amplification schemes, such as Direct Injection (DI) or Buffered Direct Injection (BDI) architectures.

In an exemplary embodiment, the photodiodes are formed from a heterostructure with a large band gap at the surface of the photodiode collection nodes where the photodiode connects to the pixel circuits. A potential advantage being reduction of noise currents flowing in and out of the surface associated with generation and recombination of charge carriers, for example, due to Shockley Read Hall traps and surface defects e.g., surface impurities and/or crystalline non-idealities and/or unsatisfied dangling bonds.

In some embodiments, the imaging system is a multi-functional system, for example, configured to operate at various different light levels and/or resolutions. For example, where functions may include one or more of; laser pulse recognition, event-based imaging, and range measurement. Although "charge sharing" where a mix of inactive and active pixels are used, is described herein with respect to imaging, applying the described system and/or technique/s is envisioned and encompassed for other uses of pixelated detectors e.g., for range measurement.

For example, in some embodiments, a pixelated system is used in recognition and/or identification of laser pulses. For example, in determining arrival (e.g., time of arrival) of a laser pulse, e.g., in range-finding applications. In this case, accuracy in terms of position as provided by which pixel/s sense the laser pulse arrival may be sacrificed for sensitivity (e.g., where the strength of the laser pulse is low with respect to the ability of the system to identify its arrival). Where, for example, according to technique/s and/or system/s as described in this document, a portion of the laser-detecting pixels are biased to be inactive.

In some embodiments, a same system is used for both imaging of light (e.g., infrared light) and for detection of laser pulses (e.g., a multi-function system which both acquires images and determines range using reflected laser pulses) the mix of inactive and active pixels may be used for both functions. Alternatively, in some embodiments, images may be acquired with a different biasing set up to measure laser pulses and image, where, for one mode (imaging acquisition mode and laser pulse detection mode) a different selection of pixels may be inactive.

Where, in some embodiments, biasing as described herein to increase an effective pixel pitch is selectively employed e.g., based on light level. Where, in some embodiments, pixel units are selectively activated and/or deactivated to increase an effective pixel pitch and/or effective collection area (e.g., above that provided by activating all of the pixel units), for example, for low light level (LLL) operation.

In an exemplary embodiment, readout circuitry of the pixel circuit/s includes a charge trans-impedance amplifier (CTIA). Potential benefits of using CTIA include fixed and/or stable diode biasing and/or large bandwidth.

Where stable diode biasing may be associated with large CTIA input impedance.

CTIA may provide a large bandwidth (e.g., when compared to DI) when DI suffers from a low pass filtering effect at the detector node. A low pass filtering effect may be more problematic (in terms of its effect on the signal e.g., SNR) when photocurrent is low e.g., under LLL.

In some embodiments, to implement active and inactive biasing of different pixel circuits of the PCA, existing biasing lines are used. Where, in some embodiments, power supply circuitry (also herein termed "driving circuitry" or "biasing circuitry") is configured to provide different bias voltages at different rows of the PCA. In some embodiments, for example to inactively bias a portion of pixel circuits of a row, additional biasing line/s are fabricated in the ROIC.

In some embodiments, Correlated Double Sampling (CDS) technique/s are used along with biasing techniques as described in this document e.g., for LLL scenario/s.

In an exemplary embodiment, read-out circuitry of the pixel units are CTIA-based (capacitive transimpedance amplifier based), which, in some embodiments, is combined with CDS technique/s e.g., for LLL scenario/s.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways.

FIG. 1 is a simplified schematic of a portion of an imaging system **100,** according to some embodiments of the disclosure.

In some embodiments, system **100** includes an array **102** (also herein termed "focal plane array (FPA)" and "photodetector array") of photodetectors, also herein termed "optical detectors", "optical sensors", "detectors", and "pixels". Where, in some embodiments, one or more photodetector of the array (e.g., each photodetector) includes a photodiode.

Where exemplary materials for the photodetector array include, for example, direct bandgap materials, IV materials (e.g., silicon), III-V materials, II-VI materials where structure of the FPA wafer may be monolithic, or a heterostructure. In some embodiments, material and/or structure of the photodiodes is selected based on desired detection wavelength/s. In some embodiments, the photodiodes are infrared radiation detecting photodiode e.g., the photodiode including InGaAs, InSb, or HgCdTe.

In some embodiments, system **100** includes a readout integrated circuit (ROIC) **104** which hosts an array of pixel circuits (also herein termed "pixel circuit array" PCA).

The ROIC may be hosted by a different wafer and/or be formed using different materials than the FPA. In an exemplary embodiment, the PCA is disposed on a ROIC **104** underneath FPA **102.**

Alternatively, in some embodiments, photodiodes of the FPA and pixel circuits of the PCA are integrated on a single wafer where their substrates may be electrically separated and/or isolated from each other.

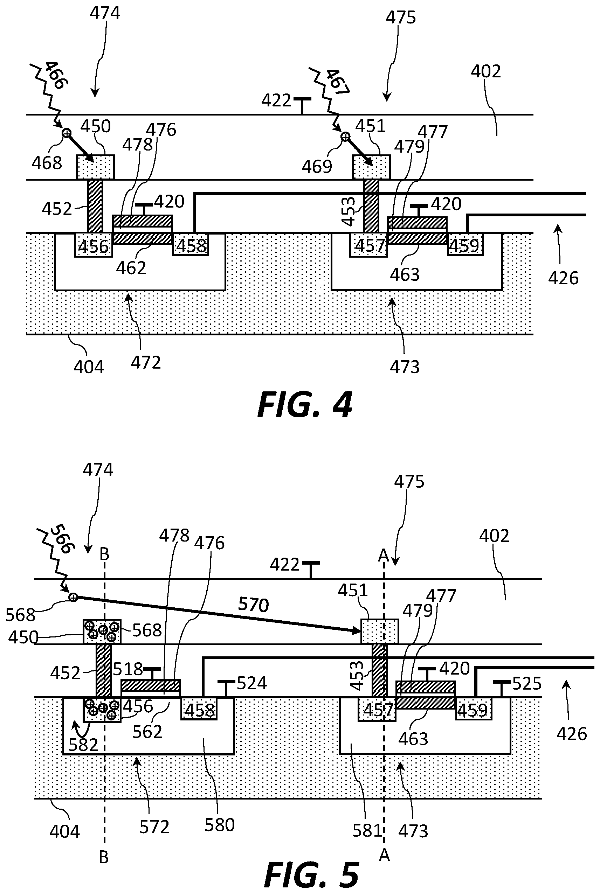

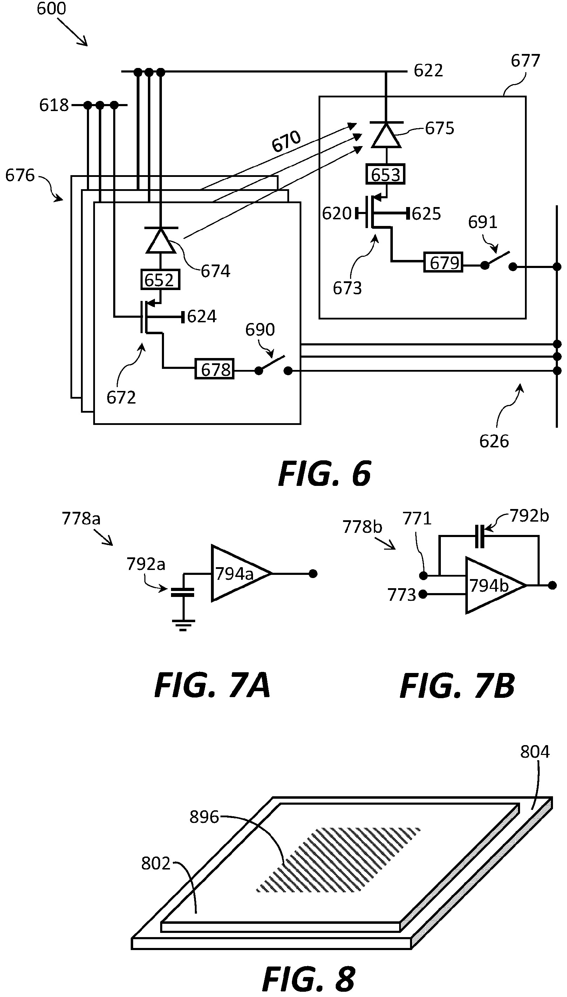

In some embodiments, each detector of the photodetector array of FPA **102** is associated with a pixel circuit of the PCA. In some embodiments, each photodetector is associated with a single corresponding pixel circuit of the PCA, where each pixel circuit, in some embodiments, includes a pixel transistor (e.g., transistors **472, 473** FIG. 4, transistors **572, 574,** FIG. 5, transistors **672, 673** FIG. 6).

In some embodiments, each pixel circuit is connected to a photodiode of FPA **102** to provide a "pixel unit". Where, in some embodiments, connectors connect each photodiode to a corresponding pixel circuit (e.g., photodiode **328,** connector **352,** pixel circuit **330** FIGs. 3A-B). In some embodiments, measurement signals (e.g., voltage and/or current and/or charge) at the pixel circuits is transferred to read circuitry **106** e.g., via connections **126.**

In some embodiments, each pixel circuit includes read-out circuitry e.g., for collecting photocurrent and/or driving the photocurrent outside the pixel array. In some embodiments, the read-out circuitry (e.g., for each pixel circuit) includes one or more integration element/s (also herein termed "accumulation element/s" and "charge accumulators") e.g., for storage of detection charge received from the photodiode connected to the pixel circuit. In some embodiments, read-out circuitry includes one or more amplification element/s (e.g., for amplification of the detection charge) and/or switching circuitry (for selective reading of the detection charge by transfer of the charge to read circuitry). Exemplary pixel units **676, 677** are illustrated in and/or described regarding FIG. 6.

In some exemplary embodiments, PCA includes 100K-20M pixel circuits, or 300K-10M pixel circuits, or 300K-5M pixel circuits, or lower, or higher, or intermediate numbers, or ranges.

In some embodiments, biasing for element/s of FPA **102** and/or the PCA is provided by one or more on-chip power supply **108.** Where, in some embodiments, on-chip power supply **110** receives power from an off-chip power supply **108.**

In some embodiments, power supply **110** provides one or more of; gate biasing for inactive transistors **118,** gate biasing for active transistors **120,** biasing **122** of photodiodes of the FPA, and substrate biasing **124** for transistors of the PCA.

In some embodiments, ROIC hosts a processing unit **112** which, for example, includes on-chip memory and/or processing circuitry. In some embodiments, imaging system 100 includes off-ROIC memory and processing circuitry (MPC) **114** which is, for example, connected to on-chip processing unit **112.**

Where, in some embodiments, power supply **110** biases one or more portion of ROIC according to control instructions received from MPC **112** and/or MPC **114.** Where, in some embodiments, portion/s of ROIC (e.g., including power supply and/or processing circuitry portion/s) responsible for biasing of inactive and/or active pixel transistors are herein termed "driving circuitry" or "biasing circuitry".

In some embodiments, imaging system **100** includes one or more user interface/s **116** which are e.g., configured to receive inputs from and/or display data received a user. Where user interface/s **116** are connected to, for receipt of and/or output of data, one or both of MPCs **112, 114.**

Optionally, in some embodiments, imaging system **100** includes one or more additional element/s. For example, where pixel circuits of the PCA include pixel multi-functional circuits. For example, element/s (e.g., at one or more pixel circuits e.g., at each pixel circuit) for one or more of laser detection, laser detection, event imaging, range finding.

FIG. 2 is a detection method, according to some embodiments of the disclosure.

At **200**, in some embodiments, which pixels of a FPA to be biased into an active configuration and which pixels to be biased into an inactive configuration are selected.

In some embodiments, a density of active pixels (e.g., as defined by a ratio of inactive pixels to active pixels) is selected e.g., to provide an effective pixel detection area and/or effective pixel pitch e.g., which is different to (e.g., larger than) that provided by activating all of the pixels.

Optionally, in some embodiments, density of active pixels is selected separately for different portions of the FPA, for example, where density of active pixels in different portions of the FPA may be different e.g., as illustrated in and/or described regarding FIG. 8.

Optionally, in some embodiments, the density and/or number and/or proportion of activated pixels is selected based on light levels. Where, in some embodiments, density of active pixels in different portions of FPA is selected by light levels e.g., for each portion. Where light level data used in the selection, in some embodiments, includes previously acquired measurement data.

Optionally, in some embodiments, the density and/or number and/or proportion of activated pixels is selected based on a protocol including a series of stipulated densities/numbers/proportions. For example, where, in some embodiments, imaging is an iterative process whereby imaging is repetitively performed with, for at least one portion of the pixel unit array, a series of densities/numbers/proportions. For example, in an exemplary embodiment, one or more image is initially acquired where at least one portion of the pixel array has a first density/number/proportion (e.g., where all pixels in the at least one portion are active) and a successive (or more than one successive images) are acquired with a reduced density/number/proportion. In some embodiments, imaging is performed where the at least one portion has reduced density/number/proportion more than once.

At **202**, in some embodiments, pixel units selected to be active are biased (also termed "driven") to an active state e.g., where the pixel circuit transistors are biased into an on state, and non-active pixel transistors are biased into an off state.

At **204**, in some embodiments, image/s with effective are acquired using the FPA and associated pixel circuitry of the ROIC, where the effective resolution of the image/s is lower, at least in parts of the FPA, than that provided by the FPA pixel density.

FIG. 3A is a simplified schematic of a portion of an FPA **302** and an ROIC **304,** according to some embodiments of the disclosure.

In some embodiments, FPA **302** and ROIC **304** are different wafers (e.g., having different materials) where photodiodes of FPA **302** are connected to ROIC **304** (e.g., by connectors e.g., connectors FIG. 3B). Alternatively, in some embodiments, FPA **302** and ROIC **304** are provided by a single monolithic wafer, where, for example, FPA and ROIC are implemented at different layers of the wafer.

In some embodiments, each region of FPA **302** hosting a photodiode corresponds to a region hosing a connected pixel circuit (e.g., region **328** of FPA **302** connected to region **330** of ROIC **304**). Although lines on FPA **302** illustrate different regions of FPA **302** associated with different photodiodes, it should be understood that, in some embodiments, there is no physical separation between photon absorbing and/or substrate regions in the photodiodes of the FPA. Where, in some embodiments, the photodiode array is delineated by separated wells of differently doped material. For example, where a FPA wafer and/or substrate and/or photon absorbing layer includes n-type material, photodiodes are provided by separately delineated p-type wells e.g., as illustrated in FIG. 4 and/or FIG. 5.

FIG. 3B is a simplified schematic of a portion of a PCA of an ROIC **304**, according to some embodiments of the disclosure.

In some embodiments, FIG. 3B illustrates an embodiment were, for a portion of rows of the PCA, more than one bias line provides more than one biasing voltage for transistors of the row of the PCA. The bias lines enabling, for example, activation of a portion of the pixel circuits of the row and switching off of a portion of the pixel circuits in the row.

FIG. 3B, in some embodiments, illustrates ROIC **304** of FIG. 3A without FPA **302**. Visible in FIG. 3B are connectors **352.** Where, in some embodiments, each photodiode of the FPA is connected by a connector to a corresponding region of ROIC **302** e.g. connector **352** connecting region **328** (FIG. 3A) to region **330.** In some embodiments, connectors **352** include micropads. In some embodiments, connectors **352** include indium bumps. In some embodiments, connectors **352** include copper-to-copper connections.

FIG. 3B, in some embodiments, illustrates biasing circuitry of active and inactive pixel circuits. Where an exemplary configuration including active pixel circuits and inactive pixels circuits is illustrated by shading of the active pixel circuits (e.g., active pixel circuit **354**) and black colored gate biasing circuitry **320** for the active circuits. Inactive pixel circuits being illustrated unshaded (e.g., inactive pixel circuit **330**) having grey colored gate biasing circuitry **318.**

In some embodiments, pixel circuits each have connection to connections **326** to reading circuitry (not illustrated).

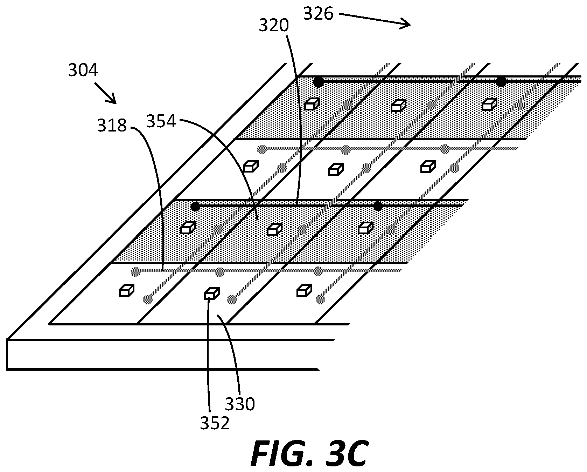

FIG. 3C is a simplified schematic of a portion of a PCA of an ROIC, according to some embodiments of the disclosure.

FIG. 3C illustrates an embodiment where rows of the PCA have a single biasing line, where rows are selectively activated (shaded pixel circuits) and switched off e.g., as described elsewhere in this document. A potential advantage of the embodiment of FIG. 3C is that changes to existing ROIC circuitry may be made in the driving circuitry e.g., without making changes to the PCA.

FIG. 4 is a simplified schematic cross section of a portion of a detector array **402** and an ROIC **404**, according to some embodiments of the disclosure.

FIG. 4, illustrates exemplary structures for photodiodes **474**, **475** of FPA **402** and transistors **472**, **473** of pixel circuits of ROIC **404.**

Photodiodes **474**, **475** each have a collection node **450**, **451** respectively.

Transistors **472**, **473** each have an input node **456**, **457** connected to a corresponding photodiode collection node, collection nodes **450**, **451** respectively.

Where the exemplary transistors **472**, **473** are MOSFETs, each having a source **458**, **459**, drain **456**, **457**, and gate **476**, **477** separated from a channel region **462**, **463** by an oxide layer **478**, **479**. Although illustrated is an MOSFET implementation it should be understood that, in some embodiments, other transistor type/s are employed e.g., bipolar junction transistors (BJTs).

Exemplary photodiodes **474**, **475** of FPA **402**, in some embodiments, are provided by regions **450**, **451** oppositely doped to material of the FPA waver. For example, where FPA waver **402** includes n-type material, in some embodiments, regions **450**, **451** are p-doped.

In FIG. 4, both a first transistor **472** and a second transistor **473** are biased into active configurations, where, for example, biasing of gates **476**, **477**, to an active transistor gate bias voltage **420** (which voltage may depend on voltages downstream via connection circuitry **426** e.g., voltages downstream associated with detection circuitry e.g., read-out circuitry type) allows carrier conduction through channel regions **462**, **463** (e.g., biasing populates the channels with carriers). Where charge carriers **468**, **469**, (generated upon absorption of photons **466**, **457** respectively) pass from photodiodes **474**, **475**, through connectors **452**, **453**, channels **462**, **463**, and connection circuitry **426** to read-out circuitry (not illustrated).

In some embodiments, a body of FPA **402** is biased to a voltage Vdetcom **422** to reverse bias photodiodes **474**, **475**, where active transistors **472**, **473** are biased to an active transistor gate bias **420** to allow charge carriers from photodiodes **474**, **475** to pass towards read-out circuitry e.g., via connection circuitry **426.**

Where, for a p-type system (on-n type system) in some embodiments, Vdetcom > active transistor gate bias **420**. In some embodiments, the active transistor gate bias may be selected according to detection circuitry e.g., as described with regards to FIGs. 7A-B.

In some embodiments, transistors **472**, **473** are p-type, a p-type region **450**, **451** of each photodiode connected to a drain **456**, **457** of a corresponding transistor **472**, **473**.

When transistors **472**, **473** are p-type, in some embodiments, the transistors are formed by fabrication (e.g., of p-type wells forming source and drain) over an n-well on a p-type wafer e.g., as illustrated in FIG. 4 if dotted shaded regions are p-type and non-shaded regions are n-type.

FIG. 5 is a simplified schematic cross section of a portion of a detector array **402** and an ROIC **404**, according to some embodiments of the disclosure.

In some embodiments, FIG. 5 illustrates a same cross section as that of FIG. 4, e.g., where like components have like numerals. However, in FIG. 5, first transistor **572** is biased into an off configuration, to provide a "inactive" transistor, where second transistor **473**, in some embodiments, (e.g., as illustrated in FIG. 5) is an adjacent transistor biased into an active configuration (to be an "active" transistor).

With biasing of active transistor **473** and photodiodes **474**, **475** of FPA **402** for example, as described regarding FIG. 4.

In some embodiments, inactive transistor gate biasing **518** of gate **476** of inactive transistor **572**, is to voltage Vcc, which is configured to prevent carrier conduction through channel region **562** (e.g., the gate biasing depletes the channel of carriers). Where Vcc **518**, in an exemplary embodiment, is larger than the voltage Vdetcom **422** reverse biasing the photodiodes; Vcc > Vdetcom.

Gate biasing **518**, **420** may be influenced by transistor characteristic/s and/or conditions. For example, by one or more of, doping, gate oxide thickness, body effect, gate leakage current, channel length modulation effects, and temperature.

Without wanting to be bound by theory, it is theorized that biasing of inactive transistor **572** produces a potential well at the connecting portions **450**, **456** of inactive transistor **572** and associated photodiode **474**. Where connecting portions **450**, **456** are also herein termed "adjacent hybridized regions" and "floating nodes" which, in some embodiments have a same dopant category (e.g., p-type). It is theorized that the floating nodes collect photo-carriers **568** (e.g., for p-on-n photodiodes and p-channel transistors the photo-carriers are positive, and are also herein termed "holes") driving potential of the floating nodes to a positive value. Where, it is theorized, the potential at the floating node Vfn, once the potential well is filled, is higher than diode biasing Vdetcom **422**; Vfn > Vdetcom. The potential at the floating node, it is theorized, acts as a barrier preventing (e.g., once the potential well is filled) additional photo-carriers **566** from entering the floating node, upon the potential well being filled, the floating node reaching an equilibrium state. After equilibrium of the floating node is achieved, additional photo-carriers generated **566**, it is theorized, are transferred by diffusion **570** through FPA wafer **402** to active diode **475** where they are collected e.g., through active transistor **473** e.g., to charge a connected integration capacitor (not illustrated).

It is theorized that, once equilibrium of the floating node is reached, the transfer process of generated charge carries continues (e.g., is constant) as long as the equilibrium is maintained. If there is leakage of carriers, from the floating node potential well e.g., leakage **582** of carriers from transistor terminal (e.g., drain) **456** to a substrate **580** of inactive transistor **572**) it is theorized that generated carriers will, e.g., instead of diffusing to be detected at the active pixel circuit, be acquired by the floating node. Where this potentially reduces the detection signal to noise ratio (SNR) e.g. as the detection signal collected at the active pixel circuit is reduced and/or detection noise is increased.

In some embodiments, substrate **580** of inactive transistor **472** is biased (e.g., reverse biased) to a voltage Vhigh **524**. Where, in some embodiments, the substrate biasing Vhigh **524** is to a higher voltage (more positive for a p-type system) than that of the reverse bias of diodes of FPA **402** e.g., for a p-type system Vhigh **524** > Vdetcom **422**. A potential benefit being prevention and/or reduction of charge transfer **582** (leakage) from the floating node e.g., from transistor drain **456** to substrate **580.** In an exemplary embodiment, Vhigh is 0.1-1V, or 0.2-0.8V, or 0.4-0.6V, or about 0.5V, above Vdetcom, or lower, or higher, or intermediate voltages above Vdetcom.

Optionally, a substrate **581** of active transistor **473** is biased to the same voltage as substrate **580** of inactive transistor **572** (voltages **524, 525** are the same), a potential advantage being the ability to provide biasing circuitry of the substrates in a dense and/or symmetric fashion.

In an exemplary embodiment, where the photon absorbing layer is p-type biasing voltages are according to the relationship:

$$Vhigh\ 524,\ 525 > Vdetcom\ 422 > Vcc\ 518 > Vbias\ 420$$

If the photon absorbing layer of the photodiodes is n-type, the biasing voltages may be according to the relationship:

$$Vhigh\ 524,\ 525 < Vdetcom\ 422 < Vcc\ 518 < Vbias\ 420$$

Where, in some embodiments, substrate reverse biasing is to Vhigh, photodiode reverse biasing is to Vdetcom, inactive transistor gate biasing is Vcc, and active transistor gate biasing is Vbias or lower.

Although illustration in FIG. 5 is of two transistors **572**, **473** and associated photodiodes **474**, **475**, it should be understood that the description is applicable to a plurality of such transistors where a proportion of the pixel units of the imaging system are biased active and at least one of the pixel units is biased inactive.

FIG. 6 is a simplified schematic of circuitry of a portion of an imaging system **600**, according to some embodiments of the disclosure.

In some embodiments, system **600** includes a plurality of ROIC pixel units **676**, **677** (also herein termed "pixel units"). Where each pixel unit, in some embodiments, includes a photodiode **674**, **675** of an FPA (e.g., FPA 102 FIG. 1, FPA **302** FIG. 3A, FPA **402** FIG. 4 and FIG. 5) and pixel circuitry of the ROIC corresponding to the photodiode. In some embodiments, each pixel unit includes a connector **652**, **653** connecting each diode to a corresponding pixel circuit (connectors **652**, **653** e.g., corresponding to connectors **352** FIG. 3B).

In some embodiments, a proportion of pixel units are in an active configuration **677** and a proportion of pixel units **676** are in an inactive configuration. In some embodiments, for each active pixel unit, at least one pixel unit is inactive, or 1-50, or 1-10, or 1-4 pixel units, or lower, or higher, or intermediate ranges, or numbers of pixel units, are inactive for each active pixel unit. In an exemplary embodiment, increase in effective detection area per active pixel (e.g., as defined by inactive pixels around each active pixel) is increased symmetrically, for example, where for each active pixel unit, there are 4, or 8, or 16, or 25, or larger square numbers of inactive pixels.

In some embodiments, fewer pixel units are inactive than those which are active. In some embodiments, a proportion and/or distribution of active pixels, for one or more region of the detector, is selected to increase the effective area associated with each active pixel symmetrically, for example, for each active pixel, there being 1, or 4, or 9, or 16, or 25, or larger square numbers of inactive pixels.

In some embodiments, different portions of the FPA have different proportions of active pixel units and inactive pixel units, e.g., including one or more feature as illustrated in and/or described regarding FIG. 8.

In some embodiments, system **600** is operable in a configuration where a portion of the pixel units are active **677** (e.g., by biasing a transistor **620** of the pixel circuit to an on configuration) and a portion of the pixel units **676** are inactive, transistor/s **672** of the inactive pixel circuits biased to an off configuration.

In some embodiments, pixel circuitry (e.g., for each pixel unit **676**, **677**) includes a transistor **672**, **673**, integration and amplification circuitry **678**, **679.** Optionally, in some embodiments, pixel units include read circuitry **690**, **691**, **626.**

In some embodiments, (e.g., for active pixel units **677**) integration and amplification circuitry **679** (also herein termed "read-out circuitry") stores charge received from photodiodes **674**, **675** through transistor **673** and then transfers the charge to read circuitry external to the pixel units (e.g., read circuitry hosted by processing unit **112** FIG. 1) e.g. when a switch **691** is closed. In some embodiments, read-out circuitry is configured to store charge received (e.g. charge stored by integration capacitor/s).

In some embodiments, read-out circuitry, which may be hosted fully or partially by pixel units e.g. read-out circuitry **678**, **679** (e.g. including integration and amplification circuitry) includes circuits employing one of capacitive transimpedance amplifiers (CTIA), direct injection (DI), buffer direct injection (BDI), source-follower per detector (SFD), gate-modulation input (GMI), share-buffered direct injection (SBDI), switch current integration (SCI).

In an exemplary embodiment, read-out circuitry, which may be hosted fully or partially hosted by pixel units e.g. read-out circuitry **678**, **679**, includes circuits employing capacitive transimpedance amplifiers (CTIA), direct injection (DI), buffer direct injection (BDI), and source-follower per detector (SFD).

Specific exemplary embodiments for read-out circuitry **678**, **679** are illustrated in FIG. 7A and FIG. 7B.

Where, in some embodiments, exemplary read-out circuity includes one or more feature of those illustrated in and/or described in: "Focal-plane-arrays and CMOS readout techniques of infrared imaging systems" to Hsieh et. al., Circuits and Systems for Video Technology, IEEE Transactions on. 7. 594 - 605. 10.1109/76.611171 which is herein incorporated by reference in its entirety.

In some embodiments, DI & BDI read-out circuity are used for larger capacity imaging where the integrator capacitor is able to accumulate large amounts of charge e.g., where photocurrents are high with respect to exposure (e.g., frame rate associated with frequency of discharge of integration capacitors).

FIGs. 7A-B are simplified schematics of exemplary read-out circuitry, according to some embodiments of the disclosure.

FIG. 7A illustrates exemplary direct injection (DI) read-out circuitry **778a** which, for example, includes an integration capacitor **792a** and a read out amplifier **794a.** Where, in some embodiments, active pixel transistors (e.g., referring back to FIG. 6, active transistor **673**) form part of read-out amplification circuitry. For example, in some embodiments, gate biasing **620** of the active pixel transistors **673** is selected so that the transistor operates as a current buffer while defining the diode voltage. The source of the DI transistor is connected to the diode defining this node voltage value at Vbias+Vthreshold.

FIG. 7B illustrates exemplary CTIA read-out circuitry which, for example, includes an integration capacitor **792b** and a CTIA amplifier **794b.** Where transistor outputs are connected to an integration CTIA amplifier first input **771** and a second input to CTIA amplifier **773** is biased to a reference voltage VREF. In some embodiments, the CTIA biasing voltage is lower than the voltage used to bias the gate of the inactive transistor, Vcc: VREF < Vcc. In some embodiments, VREF is lower than Vcc by 50-500mV, or 100-500mV, or 100-400mV, or lower, or higher, or intermediate voltages, or ranges. In some embodiments, VREF being lower than Vcc ensures active operation of the amplifier and/or active transistor.

Integration capacitor **792b** providing feedback across CTIA amplifier **794b.** In some embodiments, for example, associated with feedback of capacitor **792b**, active transistor **625** is biased at gate/base **620** to a voltage lower than the CTIA biasing voltage VREF, less a threshold voltage; VREF-VThreshold, where the threshold voltage VThreshold is a voltage required to activate the active transistor/s. For example, where gate/base voltages of VThreshold, or below, switch current flow on through the active transistor.

A potential benefit of CTIA read-out circuitry is the ability to select reset voltage, potentially providing the ability to have a large dynamic range for the same supply voltage.

FIG. 8 is a simplified schematic of a portion of an imaging system, according to some embodiments of the disclosure.

In some embodiments, different regions of a FPA **802** and/or PCA of an ROIC **804** have different proportions of activated pixels (e.g., activated detector pixels of the FPA and/or activated pixel circuits of the PCA). For example, where regions of FPA **802** and/or PCA **804** may have different proportion of activated pixels. For example, in some embodiments, shaded central region **896** illustrates and embodiment where the central region (e.g., including a plurality of pixels) has a higher proportion of activated pixels than peripheral regions of the FPA and/or PCA. For example, the detector having a higher effective resolution in a central region (e.g., where the central region is "hotter") and the peripheral regions have lower effective resolution to minimize noise (e.g., where the peripheral regions have LLLs).

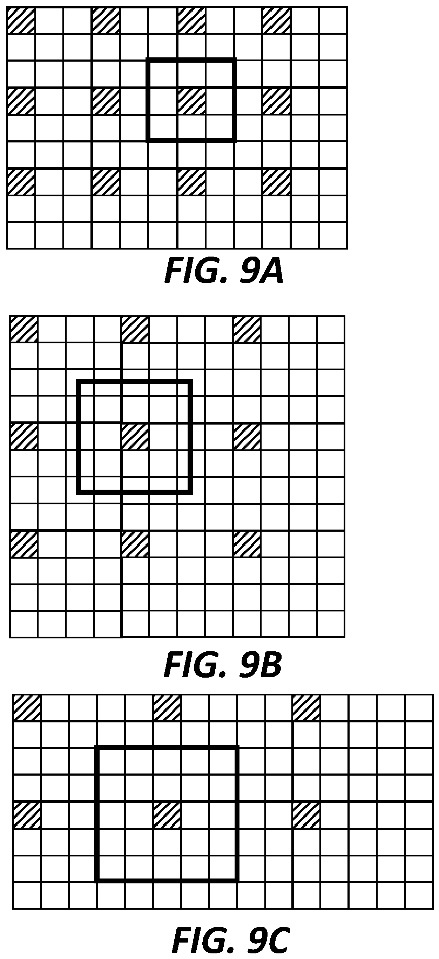

FIGs. 9A-C are simplified schematics illustrating layout of active and inactive pixels of imaging system portions, according to some embodiments of the disclosure.

Where, for example, FIG. 9A illustrates a ratio of 1:8, FIG. 9B illustrates an embodiment with a ratio of 1:15 where pixel areas are potentially divided between active pixels, and FIG. illustrates a ratio of 1:24. In some embodiments, exemplary ratios include ratios of 1:(square numbers - 1).

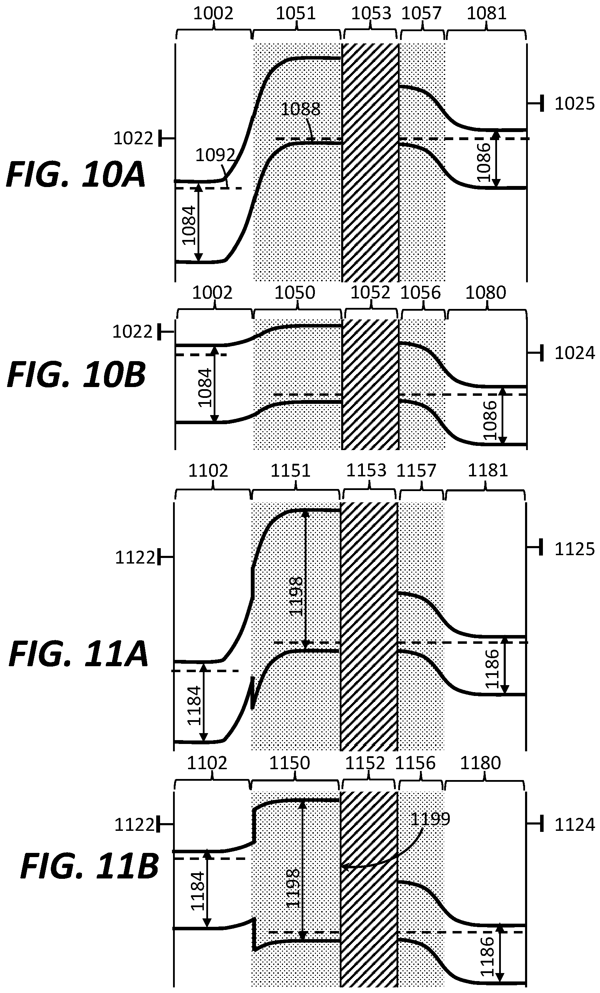

FIGs. 10A-B are simplified schematic band diagrams, according to some embodiments of the disclosure.

FIG. 10A, in some embodiments, illustrates a band diagram for a cross section taken along line AA in FIG. 5, a cross section through an active photodiode and transistor.

FIG. 10B, in some embodiments, illustrates a band diagram for a cross section taken along line BB in FIG. 5, a cross section through an inactive photodiode and transistor.

Reference numerals for the layers and biasing, in some embodiments, correspond to those of FIG. 5, for example, element **402** corresponding to element **1002** and element **525** corresponding to **1025.**

FIGs. 10A-B illustrate an embodiment where the photodiodes are hosted by a first material having a different bandgap **1084** than a bandgap **1086** of a second material of the connected transistor. The first material may be a direct bandgap material, the second material may be silicon.

FIGs. 10A-B illustrate a p-type system (p-on-n) where substrates **1002**, **1080**, **1081** are n-type, photodiode collection nodes **1050**, **1051** are p-type, and input nodes **1056**, **1057** are p-type. As discussed previously, in some embodiments, the system is n-type and band diagrams should correspondingly be inverted. Conducting connectors **1052**, **1053**, provide fermi levels (FL) indicated as dashed lines either side of connectors **1052**, **1053** having the same energy.

In some embodiments, the first material is indium gallium arsenide (InGaAs) and the second material is silicon (Si). The photodiode substrate **1002** including n-type InGaAs, the photodiode collection nodes **1050**, **1051** including p-type InGaAs, the transistor input nodes **1056**, **1057** including p-type Si, and the transistor substrates **1080**, **1081** including n-type Si.

In FIG. 10A which illustrates an active pixel unit, the photodiode (**1002**, **1051**) is reverse biased where a FL **1092** of n-type photodiode substrate **1002** is lower than FL **1088** of p-type photodiode collection node.

FIG. 10A illustrates an embodiment where the transistor input node-transistor substrate **1057-1081** p-n junction is in equilibrium (not under bias) i.e., has constant voltage across the junction as illustrated by the fermi level being constant from that of the photodiode collection node; FL **1088** across connector **1053** to input node **1057.** Photo-holes which are collected from the reverse biased photodiode **1002-1051** flow into the p-type input node **1057** and are then collected, flowing through the transistor channel (e.g., in a direction normal to plane of the figure e.g., referring to FIG. 5, along channel **1063**), it is theorized, the transistor channel controlling the position of the input node **1057** FL. The transistor substrate bias potential **1025**, in some embodiments, is configured (e.g., along with other transistor characteristics) to hold the input node p-n junction **1057-1081** in equilibrium.

In some embodiments, e.g., where the potential on **1025** is insufficiently negative the p-n junction **1057-1081** will be in reverse bias (not illustrated) potentially resulting in a small reverse bias leakage current of the input node - substrate p-n junction **1057-1081** which, in some embodiments, is assumed to be negligible compared with the photocurrent.

In FIG. 10B, illustrating the inactive pixel unit, the photodiode (**1002**, **1050**) is forward biased, this may be illustrative of a local region of the photodiode array e.g., adjacent to the photodiode collection node, the change from reverse bias (as experienced by the active photodiode **1002**, **1051**) changing to forward bias locally as associated with collection of charge at the inactive photodiode collection node **1050** (e.g., as illustrated in FIG. 5 where charges have accumulated at collection node **456**).

In some embodiments, biasing **1024** of the inactive transistor is sufficiently positive to prevent the p-n junction of the substrate-input node **1080-1056** from becoming forward biased and leaking accumulated holes into substrate **1080.** FIG. 10B illustrates an embodiment where the p-n junction **1080-1056** is in equilibrium. In some embodiments, e.g., to achieve this equilibrium, biasing of substrate **1080** is to a more positive voltage (p-type configuration) than biasing of the photodiode **1022.**

In some embodiments, the p-n junction **1080-1056** may be reverse biased. This may result in injection of holes from the silicon substrate into the inactive transistor input node potentially then producing a reverse bias photodiode current. This reverse bias photodiode current may then be collected by active photodiodes.

FIGs. 11A-B are simplified schematic band diagrams, according to some embodiments of the disclosure.

FIG. 11A, in some embodiments, illustrates a band diagram for a cross section taken along line AA in FIG. 5, a cross section through an active photodiode and transistor.

FIG. 11B, in some embodiments, illustrates a band diagram for a cross section taken along line BB in FIG. 5, a cross section through an inactive photodiode and transistor.

Reference numerals for the layers and biasing, in some embodiments, correspond to those of FIG. 5, for example, element **402** corresponding to element **1102** and element **525** corresponding to **1125.**

FIGs. 11A-B illustrate an embodiment where the photodiodes formed in a heterostructure where the collection node of the photodiodes has a larger bandgap than that of the photodiode substrate. The transistor may be formed of a monolithic material.

In some embodiments, photodiode substrate **1102** includes n-type InGaAs (which may have a smaller bandgap **1184** than a bandgap of the transistor material **1186** in contrast to the illustrated larger bandgap) and photodiode collection nodes **1150**, **1151** include p-type indium phosphide (InP) having a large bandgap **1198** e.g., larger than the photodiode substrate and/or the pixel circuit material/s. In some embodiments, the transistor input nodes **1156**, **1157** include p-type Si, and the transistor substrates **1180, 1181** include n-type Si.

For example, as with the embodiment illustrated in FIG. 10A, the active pixel unit has a reverse biased photodiode **1102, 1151** and a transistor input node - transistor substrate junction **1157-1181** which is in equilibrium.

For example, as with the embodiment illustrated in FIG. 10B, the inactive pixel unit is forward biased at a region of the photodiode **1102**, **1150** and a transistor input node - transistor substrate junction **1156-1180** which is in equilibrium.

It is theorized that the heterostructure having a large band gap **1198** at a surface **1199** of the photodiode collection node potentially provides reduced noise currents flowing in and out of the surface associated with generation and recombination of charge carriers, for example, due to Shockley Read Hall traps and surface defects e.g., surface impurities and/or crystalline non-idealities and/or unsatisfied dangling bonds.

**General**

As used within this document, the term "about" refers to $\pm 20\%$

The terms "comprises", "comprising", "includes", "including", "having" and their conjugates mean "including but not limited to".

The term "consisting of" means "including and limited to".

As used herein, singular forms, for example, "a", "an" and "the" include plural references unless the context clearly dictates otherwise.

Within this application, various quantifications and/or expressions may include use of ranges. Range format should not be construed as an inflexible limitation on the scope of the present disclosure. Accordingly, descriptions including ranges should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within the stated range and/or subrange, for example, 1, 2, 3, 4, 5, and 6. Whenever a numerical range is indicated within this document, it is meant to include any cited numeral (fractional or integral) within the indicated range.

It is appreciated that certain features which are (e.g., for clarity) described in the context of separate embodiments, may also be provided in combination in a single embodiment. Where various features of the present disclosure, which are (e.g., for brevity) described in a context of a single embodiment, may also be provided separately or in any suitable sub-combination or may be suitable for use with any other described embodiment. Features described in the context of various embodiments are not to be considered essential features of those embodiments, unless the embodiment is inoperative without those elements.

Although the present disclosure has been described in conjunction with specific embodiments thereof, it is evident that many alternatives, modifications, and variations will be apparent to those skilled in the art. Accordingly, this application intends to embrace all such alternatives, modifications and variations that fall within the spirit and broad scope of the appended claims.

All references (e.g., publications, patents, patent applications) mentioned in this specification are herein incorporated in their entirety by reference into the specification, e.g., as if each individual publication, patent, or patent application was individually indicated to be incorporated herein by reference. Citation or identification of any reference in this application should not be construed as an admission that such reference is available as prior art to the present disclosure. In addition, any priority document(s) and/or documents related to this application (e.g., co-filed) are hereby incorporated herein by reference in its/their entirety.

Where section headings are used in this document, they should not be interpreted as necessarily limiting.

**Claims**

**1.** An imaging system comprising:

a focal plane array (FPA) comprising a plurality of photodiodes, hosted by a shared substrate, each photodiode having a collection node;
a pixel circuitry array (PCA) comprising a plurality of transistors, an input node of a transistor of said plurality of transistors connected to each photodiode collection node of said FPA; and
biasing circuitry configured to:

selectively bias a first portion of said plurality of transistors into an inactive configuration;
reverse bias a substrate of each transistor of said first portion of said plurality of transistors; and
selectively bias a second portion of said plurality of transistors into an active configuration;
reverse bias said shared substrate to a different reverse bias than said reverse bias of each said transistor substrate of said first portion of said plurality of transistors.

2. The imaging system according to claim 1, wherein each transistor of said second portion injects photocurrent signal received from the connected photodiode collection node away from the transistor;
wherein injection of photocurrent of said transistors of said second portion prevents charge accumulation at photodiodes connected to transistors of said second portion.

3. The imaging system according to any one of claims 1-2, wherein injection of photocurrent of said transistors of said second portion maintains said reverse bias of said shared substrate.

4. The imaging system according to any one of claims 1-3, wherein said FPA is hosted by a FPA wafer, wherein said PCA is hosted by a PCA wafer which is a different wafer to said FPA wafer.

5. The imaging system according to claim 4, wherein one or more of:

said FPA wafer includes direct bandgap material;
said FPA wafer is a heterostructure;
said photodiode collection nodes include material having a wider bandgap than said shared substrate;
said photodiodes are infrared detecting photodiodes with a photon absorbing region including InGaAs, InSb, or HgCdTe; and
said PCA wafer comprises silicon and said plurality of transistors comprise metal-oxide-semiconductor field effect transistors (MOSFETs).

6. The imaging system according to any one of claims 1-5, comprising a plurality of connectors, each said transistor connected to a corresponding photodiode of said plurality of photodiodes by a connector of said plurality of connectors;
wherein said plurality of connectors comprise one of copper-to-copper connections and indium bumps.

7. The imaging system according to any one of claims 1-6, wherein first portion photodiodes of said FPA associated with said first portion of transistors are spatially interspersed on said FPA with second portion photodiodes of said FPA associated with said second portion of transistors, each active transistor of said second portion collecting photocurrent from a second portion photodiode and at least one first portion photodiode.

8. The imaging system according to any one of claims 1-7, wherein each said photodiode is connected to an input node of a transistor of said plurality of transistors;
wherein substrates of transistors of said first portion are reverse biased to reverse bias said input nodes to prevent leakage of charge from said input nodes of said transistors of said first portion to said substrates.

9. The imaging system according to claim 8, wherein substrates of transistors of said second portion are reverse biased.

10. The imaging system according to claim 9, wherein substrates of said transistors of said second portion are reverse biased to a same voltage as said substrates of said transistors of said first portion.

11. The imaging system according to any one of claims 8-10, wherein said photodiodes and transistors are implemented in a p-type configuration;

wherein substrates of said photodiodes are reverse biased to a reverse biasing voltage Vdetcom; and
wherein said substrates of said transistors of said first portion are reverse biased to a voltage Vhigh which is higher than said reverse biasing voltage Vdetcom of said photodiodes; Vhigh > Vdetcom.

12. The imaging system according to any one of claims 6-11, wherein said PCA comprises a plurality of rows of pixel circuits, wherein one or more row of pixel circuits of said pixel circuit array includes a plurality of bias lines, to bias switching terminals of different transistors of said row to different voltages; and

wherein said biasing circuitry is configured to supply different bias voltages to at least two of said plurality of bias lines;
wherein
said transistors are field effect transistors (FETs) and said switching terminals are gates of said FETs, or said transistors are bipolar junction transistors (BJTs) and said switching terminals are bases of said BJTs.

13. The imaging system according to any one of claims 6-12, wherein said pixel circuits each include read-out circuitry which includes an integration capacitor connected to a transistor of a respective pixel circuit for accumulating charge received through said transistor.

14. The imaging system according to claim 13, wherein said read-out circuitry comprises a charge trans-impedance amplifier (CTIA); or
wherein said read-out circuitry comprises direct injection (DI) read-out circuitry.

15. An imaging method for using a focal plane array (FPA) having a plurality of photodiodes hosted by a shared substrate and a pixel circuit array (PCA) coupled to the FPA and having a plurality of transistors, a transistor corresponding to each photodiode of said FPA, which method comprising:

selecting a first portion of said plurality of transistors as inactive transistors and a second portion of said plurality of transistors as active transistors;
biasing said first portion transistors into an inactive configuration and biasing said second portion transistors into an active configuration;
reverse biasing said shared substrate to reverse bias photodiodes connected to transistors of said second portion;
reverse biasing a substrate of each transistor of said first portion of said plurality of transistors to a different reverse bias than that of said shared substrate; and
acquiring one or more image using said FPA and said PCA.

100

118
120
106
126
124
112
102
104

PROCESSOR
114

122    110
USER INTERFACE/S
116

POWER SUPPLY
108

**FIG. 1**

| Select proportion of active pixels to determine a selected effective pitch | 200 |

| Drive active pixel transistors into an on state, drive non-active pixel transistors into an off state | 202 |

| Acquire image/s with effective pitch | 204 |

**FIG. 2**

**FIG. 3A**

**FIG. 3B**

FIG. 3C

**FIG. 4**

**FIG. 5**

**FIG. 6**

**FIG. 7A**

**FIG. 7B**

**FIG. 8**

**FIG. 9A**

**FIG. 9B**

**FIG. 9C**

**FIG. 10A**

1002  1051  1053 1057  1081

1022

1088

1092

1084

1025

1086

**FIG. 10B**

1002  1050  1052 1056  1080

1022

1024

1084

1086

**FIG. 11A**

1102  1151  1153 1157  1181

1122

1125

1198

1184

1186

**FIG. 11B**

1102  1150  1152 1156  1180

1122

1124

1199

1184

1198

1186

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SHIH Y-C ET AL: "A New CMOS Pixel Structure for Low-Dark-Current and Large-Array-Size Still Imager Applications", IEEE TRANSACTIONS ON CIRCUITS AND SYSTEMS PART I: REGULAR PAPERS, IEEE SERVICE CENTER, NEW YORK, NY, US, vol. 51, no. 11, 1 November 2004 (2004-11-01), pages 2204-2214, XP011122002, ISSN: 1057-7122, DOI: 10.1109/TCSI.2004.835684 * page 2206 - page 2207; figures 3,4 * | 1-15 | INV. H04N25/445 H04N25/46 H04N25/621 H04N25/709 |
| A | LESTER DE ABREU FARIA ET AL: "Design and characterization of a CMOS preamplifier for quantum well infrared photodetectors", ANALOG INTEGRATED CIRCUITS AND SIGNAL PROCESSING, KLUWER ACADEMIC PUBLISHERS, BO, vol. 73, no. 3, 24 July 2012 (2012-07-24), pages 885-894, XP035133367, ISSN: 1573-1979, DOI: 10.1007/S10470-012-9912-X * page 887 - page 888; figures 2,3 * | 1-15 | |
| A | US 2004/041219 A1 (CHAO CALVIN [US] ET AL) 4 March 2004 (2004-03-04) * paragraph [0118] - paragraph [0125] * | 1-15 | |

**TECHNICAL FIELDS SEARCHED (IPC)**

H04N

The present search report has been drawn up for all claims

| Place of search | Date of completion of the search | Examiner |
|---|---|---|
| Munich | 3 July 2025 | Penchev, Petyo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...........................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 16 9776

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2025

| Patent document cited in search report | Publication date | Patent family member(s) | Publication date |
|---|---|---|---|
| US 2004041219 A1 | 04-03-2004 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HSIEH**. Focal-plane-arrays and CMOS readout techniques of infrared imaging systems. *Circuits and Systems for Video Technology, IEEE Transactions*, vol. 7, 594-605